# EUROPEAN PATENT APPLICATION

(11) **EP 1 536 243 A1**
(43) Date of publication of application: **01.06.2005**
(21) Application number: 04025908.7
(22) Date of filing: 02.11.2004
(51) Int. Cl.: G01R 31/02, H04L 12/26

(54) **Monitoring system for communication and remote signaling lines**

(30) Priority: 26.11.2003 IT to20030944
(71) Applicant: Urmet Telecomunicazioni S.p.A., 10154 Torino (IT)
(72) Inventor: Ossini, Giovanni, 00040 Castel Gandolfo (RM) (IT)
(74) Representative: Spandonari, Carlo

(57) **Abstract**

The system monitors balanced, two-wire, ground-insulated lines by means of a plurality of test apparatuses (AT1, AT2, AT3, ...) connectable at intervals across both wires (a1, b1) of a line. Each apparatus comprises: signal-injecting means (G) for simultaneously injecting predetermined sample signals into both line wires in common mode with respect to ground or to another side-by-side line and signal-measuring means (M) for measuring the common-mode sample signal. Control means (EG) are arranged for controlling the emission and reception of the sample signals by each test apparatus.

## Description

This invention is concerned with a system for monitoring communication and remote-signaling lines.

Networks of cables have been installed over the years along distributed installations such as railways, for purposes of service communication such as voice, data and remote signaling, and they are often used today to provide additional electric signals. The cables typically comprise a plurality of balanced wire pairs, free from any galvanic reference to the electric ground providing signaling and protection.

It is now the main object of the invention to provide a system for continuously monitoring the above lines, in a non-intruding way, i.e. without interfering with regular communication carried on the lines, in order to detect, in particular, any decay or malfunction due to interruptions and to insulation defects which may give rise to shorts or leakages.

Although it is envisaged that the invention will be particularly advantageous when applied to monitoring communication lines lying along railways, the invention can be applied more generally to monitoring balanced, two-wire communication lines that are insulated from the ground, also in other fields where ordinary maintenance is automated.

The above and other objects and advantages, such as will appear from the following disclosure, are achieved by the invention by a system for monitoring communication lines that are balanced and insulated from the ground, having the features recited in claim 1.

The dependent claims set forth other advantageous features of the invention.

A preferred embodiment of the invention is described below, by way of nonlimiting example, with reference to the attached drawings, wherein:
Fig. 1 is a general block diagram of a balanced, two-wire line, on which a monitoring system is installed according to a preferred embodiment of the invention;
Fig. 2 is a circuit diagram, partly shown as a block diagram, of a test apparatus belonging to the monitoring system according to the invention, connected for monitoring a single line;
Fig. 3 is a circuit diagram, partly shown as a block diagram, of a test apparatus connected for monitoring the insulation between two adjacent lines;
Fig. 4 is a circuit diagram, partly shown as a block diagram, showing a preferred arrangement for supply and communication between the test apparatuses belonging to the system.

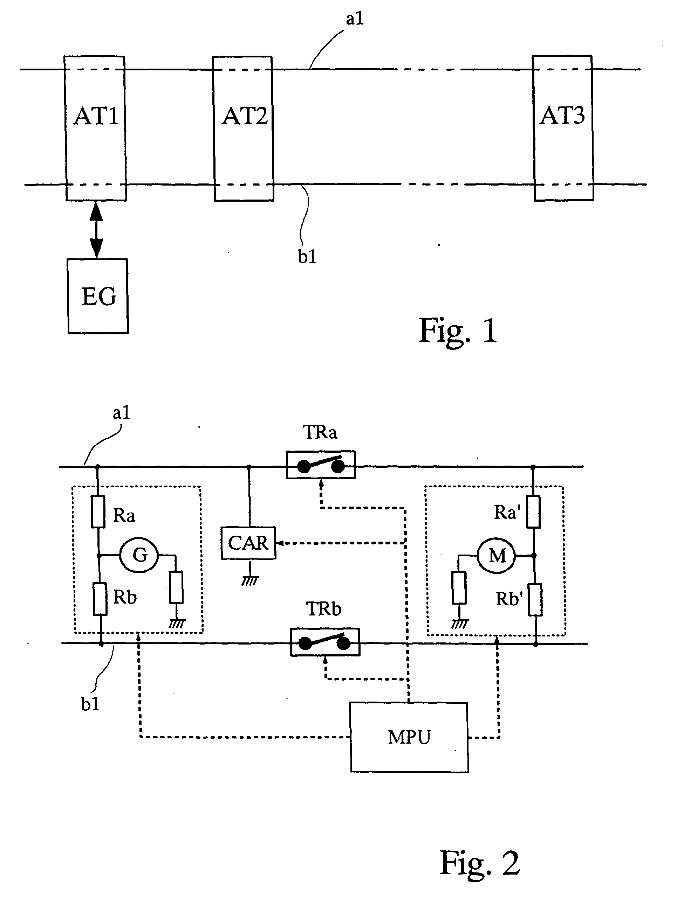

With reference to Fig. 1, a communication line comprises two wires a1, b1, which are both insulated from the ground, and dedicated to the transmission of signals in balanced form.

A plurality of test apparatuses AT1, AT2, AT3 are shunt-connected between both wires a1 and b1, for the purpose of carrying out line efficiency measurements, and described below. Apparatus AT1, which is the main test apparatus controlling the operation of the other apparatuses on the line and which receives measurement data from them, is driven by a control computer EG, which is programmed for carrying out a monitoring process that is described below.

The distances between successive test apparatuses are typically a few kilometers, but they may vary widely depending on circumstances. Typically, a number of two-wire lines are encased within a single cable, with paper-air insulation.

With reference to Fig. 2, a generic test apparatus ATn essentially comprises:
- two controlled disconnectors TRa, TRb, which are series-connected along wires a1, b1, and which are normally closed;
- a sample-signal generator G having a grounded terminal and the opposite terminal connected to the central tap of a symmetrical resistive divider Ra, Rb, that is connected across both line wires a1, b1;
- a measurer M, such as a voltmeter, similarly connected with one terminal tied to the central tap of a further symmetrical resistive divider Ra', Rb' and its opposite terminal grounded; and
- a communication module CAR, essentially comprising a modem, for receiving commands from the main apparatus AT1 and for returning to it data obtained by measurement.

A process computer MPU, including a CPU as well as memory, communicates with communication module CAR for receiving commands from it and controls the operation of disconnectors TRa, TRb, of generator G and of measurer M, as well as of the communication module CAR itself, in order to transmit measurement data.

According to the invention, the generator of each test apparatus AT1, AT2, ... cyclically injects a sample signal simultaneously into both wires a1, b1 of the two-wire line, as a "common-mode" signal, with reference to ground, and this signal is then sensed at points downstream on the line, by means of the other test apparatuses. The measurement data are transmitted from the communication modules CAR of each test apparatus to the main apparatus AT1, where the data are stored within the control computer EG.

The above monitoring, as will be apparent to a person skilled in the art, may be carried out during the regular operation of the line in the balanced mode, since both wires are simultaneously driven in common mode with respect to the ground, and their differential effect is therefore null.

Only when analysis of the monitoring data denounces an anomaly in the line, such as a decay in the insulation, can the above described system be operated to carry out more detailed tests to locate the malfunction, with interruption of the regular operation of the line. To this purpose, disconnectors TRa, TRb for successive segments of the line are opened in succession, and the same measurements are carried out, until the segment concerned is singled out.

The principle of measurement according to the invention may be applied, where a pair of two-wire lines are side by side within the same cable, also for monitoring the effectiveness of the insulation between the lines. In this case, rather than taking the real ground as a ground reference for generator G and monitoring measurer M of the generic test apparatus ATn, a virtual ground is taken, corresponding to the adjacent line.

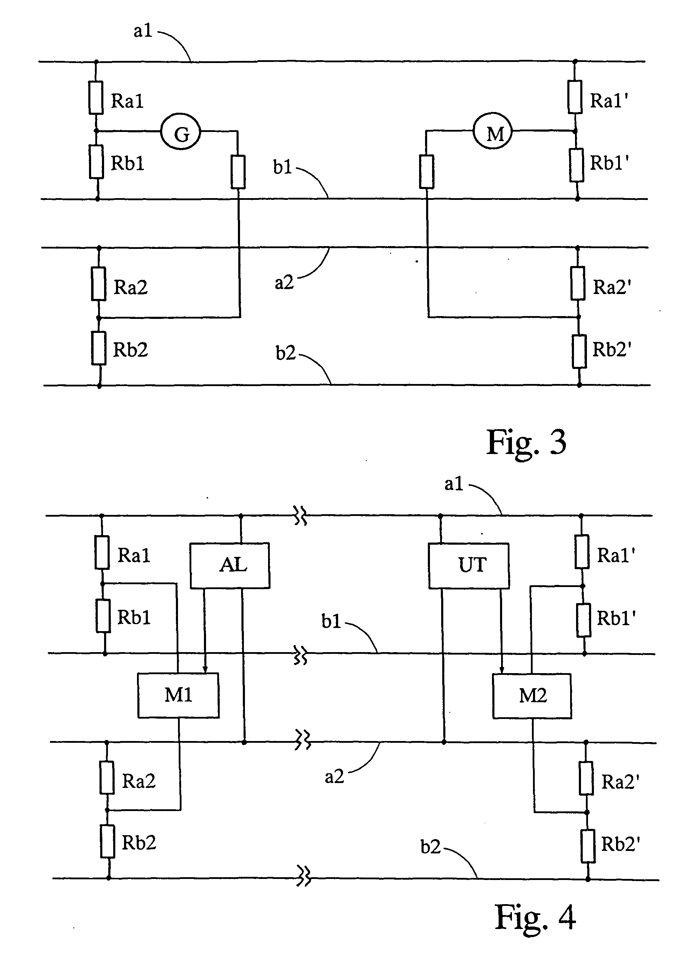

With reference to Fig. 3, two side-by-side, two-wire lines within a cable comprise respective pairs of wires a1, b1 and a2, b2. Generator G of apparatus ATn is connected with one terminal to the central tap of a symmetrical divider Ra1, Rb1 of line a1, b1, and is connected with the opposite terminal to the central tap of a similar symmetrical divider Ra2, Rb2 of the adjacent line. Measurer M is also similarly connected between a divider on the first line and a similar divider on the second line.

Although the test apparatuses can be supplied from locally available electric sources, the invention provides that they are remotely supplied from a source of d.c. voltage located at a desired point along the line, e.g. where the main test apparatus AT1 is located, the source being connected for applying a d.c. voltage to one of the wires of the two-wire line with respect to the ground, or with respect to the wire of a second two-wire line which is available and usable.

Fig. 4 shows, by way of example, the principle of remote supply as applied to two side-by-side, two-wire lines, respectively comprising pairs of wires a1, b1 and a2, b2. A remote-supply circuit AL, receiving its own supply from a source external to the line, is located at a desired point of the line, e.g. near the main test apparatus (not shown) and is connected so that it will apply a d.c. voltage across wire a1 of the first line to wire a2 of the second line. At a distance along both lines, a load UT is also connected across wires a1 and a2, with the purpose of deriving a d.c. voltage from the line, for supplying a remote test apparatus associated therewith (not shown).

Fig. 4 shows how the communication between the remote test apparatuses and a main apparatus can also take place in the same way. A modem M1, energized by supply AL and associated with a main test apparatus (not shown) is connected across the central taps of respective symmetrical dividers Ra1, Rb1 and Ra2, Rb2 for transmitting and receiving common-mode signals between the two lines, without interference with regular communication traveling along the lines. At a distance along the lines, another modem M2, which is energized by UT and is associated to a remote test apparatus not shown, is connected across the two lines by means of symmetrical dividers, in the same way.

Obviously, the same principles of remote supply and common-mode communication, which are shown on Fig. 4 for the case of two side-by-side lines, may also be applied between a single line and the ground.

Moreover, although the above disclosure of preferred embodiments is concerned with monitoring one or more side-by-side lines, it is understood that the system can be applied for an arbitrary number of lines, using permutators (not shown) to connect the generator and measurer means in turn to the desired lines, as will be obvious for a person skilled in the art after reading the teachings given above.

The above disclosed system, under control of the control computer EG, is programmed for cyclically testing all the accessible lines, two conditions being checked for each line:
- insulation from ground or from adjacent lines;
- partial or total interruption.

For the measurement of the insulation, as mentioned above, the system injects on the line, in common mode with respect to the ground or to an adjacent line, a voltage having a suitable frequency and polarity, and the degree of unbalance detected on a loop (Wheatstone bridge) is an indication of any dispersion.

When a check on line interruptions is desired, two contiguous test apparatuses, at the opposite ends of a span of a line, exchange sample signals having predetermined values with each other, and the attenuation of the span, which is proportional to the degradation of the line, is then computed, based on the level of reception.

In the installation step, a first overall scanning of all the lines under monitoring is preferably carried out, with the aim of setting up a database of the acquired data, which will be used as a reference in subsequent tests. Any deviation from these values in subsequent measurements later in time will indicate how the line quality is preserved or degraded.

More particularly, the control computer may be programmed for carrying out functions such as configuring the test apparatuses, collecting and archiving measurement data, processing and examining data, performing a statistical analysis of the data, etc. Programming the control computer for the implementation of the desired functions is no part of the invention and is obvious for a person skilled in the art.

## Claims

1. A system for monitoring balanced, two-wire, ground-insulated communication lines, **characterized in that** it comprises a plurality of test apparatuses (AT1, AT2, AT3, ...) connectable between both wires (a1, b1) of a first communication line and comprising:
- signal-injecting means (G) having a reference external to said first line, and arranged for simultaneously injecting predetermined sample signals into both line wires in common mode with respect to said external reference;
- signal-measuring means (M) arranged for measuring said sample signal transmitted in common mode between both wires wires and said external reference;
- control means (EG) for said injector means and measurer means of each test apparatus, arranged for controlling the emission of said sample signals by said signal-injecting means and for collecting the data detected by said signal-measuring means.

2. The monitoring system of claim 1, **characterized in that** the signal injector means (G) comprise a generator having one terminal connected to said external reference and its opposite terminal connected to the central tap of a first symmetrical divider (Ra, Rb) connected across both wires of said first two-wire line.

3. The monitoring system of claim 1 or 2, **characterized in that** said measurer means (M) comprise a signal detector having one terminal connected to said external reference and its opposite terminal connected to the central tap of a second symmetrical divider (Ra', Rb') connected across both wires of said first two-wire line.

4. The monitoring system of any of claims 1 to 3, **characterized in that** said external reference is the electric ground.

5. The monitoring system of any of claims 1 to 3, **characterized in that** said external reference is the central tap of a third symmetrical divider (Ra2, Rb2; Ra2', Rb2') connected across both wires of a second two-wire line (a2, b2).

6. The monitoring system of claim 1, **characterized in that** each test apparatus (AT1, AT2, AT3, ...) communicates with at least another test apparatus via one modem (M1, M2) having one terminal connected to said external reference and its opposite terminal connected to the central tap of a fourth symmetrical divider (Ra1, Rb1; Ra1', Rb1') connected across both wires of said first two-wire line.

7. The monitoring system of claim 6, **characterized in that** said external reference is the electric ground.

8. The monitoring system of claim 6, **characterized in that** said external reference is the central tap of a fifth symmetrical divider (Ra2, Rb2; Ra2', Rb2') connected across both wires of a further two-wire line.

9. The monitoring system of any of claims 1 to 8, **characterized in that** each of said test apparatuses is supplied by a d.c. voltage applied to one wire (A1) of the associated two-wire line with respect to said external reference.

10. The monitoring system of claim 9, **characterized in that** said external reference is the electric ground.

11. The monitoring system of claim 9, **characterized in that** said external reference is one wire (A2) of a further two-wire line laid side-by-side with said associated two-wire line.

12. The monitoring system of any of claims 1 to 11, **characterized in that** in each wire of said first two-wire line is series-connected a normally closed disconnector (TRa, TRb) near each of said test apparatuses, and **in that** the disconnector is operable to open under control of the associated test apparatus.
